# EUROPÄISCHE PATENTSCHRIFT

(11) **EP 3 117 458 B1**
(45) Veröffentlichungstag und Bekanntmachung des Hinweises auf die Patenterteilung: **26.01.2022**
(21) Anmeldenummer: 15718426.8
(22) Anmeldetag: 10.03.2015
(51) Int. Cl.: H01L 23/373, H01L 23/495, H01L 23/492, H01L 25/07, H01L 23/473, H01L 25/18

(54) **ELEKTRISCHE BAUTEILANORDNUNG**
ELECTRIC COMPONENT ASSEMBLY
AGENCEMENT DE COMPOSANTS ÉLECTRIQUES

(30) Priorität: 10.03.2014 AT 1712014
(43) Veröffentlichungstag der Anmeldung: 18.01.2017
(73) Patentinhaber: EGSTON Power Electronics GmbH, 3730 Eggenburg (AT)
(72) Erfinder: JAMY, Roman, 3698 Neupölla (AT); PRAND-STRITZKO, Ernst, 2091 Langau (AT)
(74) Vertreter: Gibler & Poth Patentanwälte KG
(86) Internationale Anmeldenummer: PCT/AT2015/000037
(87) Internationale Veröffentlichungsnummer: WO 2015/135010

(56) Entgegenhaltungen:
- EP-A1- 0 489 958
- EP-A1- 2 515 331
- EP-A1- 2 565 920
- DE-A1-102012 112 769
- FR-A1- 2 984 680
- JP-A- 2008 103 623
- JP-A- 2013 123 014
- US-A- 3 918 084
- US-A- 4 853 828
- US-A1- 2012 211 213

## Beschreibung

Die Erfindung betrifft eine elektrische Vorrichtung gemäß dem Oberbegriff des Patentanspruches 1.

Es sind, insbesondere im Bereich der Leistungshalbleiter, Halbleitermodule bekannt und weithin üblich, in welchen mehrere Halbleiterbauteile, wie etwa Leistungstransistoren, unmittelbar auf Substratebene aufgebaut, innerhalb eines einzigen Gehäuses angeordnet sind. Die betreffenden Halbleitermodule werden zur Wärmeabfuhr an einem Kühlkörper angeordnet.

Derartige Halbleitermodule weisen den Nachteil auf, dass diese lediglich für eine begrenzte Anzahl an Funktionen bzw. Leistungsdaten von den entsprechenden Herstellern angeboten werden, und daher nur für eine entsprechend begrenzte Anzahl an Anwendungen zur Verfügung stehen. In aller Regel sind Hersteller entsprechender Module bereit, solche auf Kundenwunsch zu entwicklen und herzustellen. Dies ist jedoch mit erheblichen Anfangskosten verbunden und rechnet sich folglich nur ab einer hohen erforderlichen Stückzahl.

Im Bereich geringer Stückzahlen, etwa beim Prototypenbau oder bei Kleinserien bzw. Sonderprodukten, können derartige Halbleitermodule daher oftmals nicht zur Anwendung gelangen. Insbesondere im Bereich der Leistungselektronik besteht dadurch das Problem die auf geringem Raum anfallende Verlustleistung bzw. Wärme von dem Halbleiterbauelement bzw. den Halbleiterbauelementen abzuführen. Die Temperatur im Bereich eines Halbleiterbauelements hat unmittelbare Auswirkungen auf dessen Lebensdauer. Die Temperatur im Bereich der Halbleiterbauelemente beeinflusst weiters das Kennfeld des betreffenden Halbleiterbauelements bzw. eine Arbeitspunkteinstellung, was bei Einsatz des betreffende Halbleiterbauelement als Verstärker unmittelbare Auswirkungen auf das Klirrverhalten der betreffenden Schaltungsanordnung hat.

Die DE 10 2012 112 769 A1 beschreibt eine Anordnung, bei welcher ein diskreter Halbleiterbauteil auf einem Direct-Copper-Bonding-Substrat angeordnet ist. Das DCB Substrat ist wiederum mit der Metallplatte verbunden, welche gemäß Absatz auch der Wärmeabfuhr dient. Das Ganze ist wiederum vergossen und bildet ein eingekapseltes Modul.

Die FR 2 984 680 A1 beschreibt eine Anordnung zu Wärmeabfuhr von einem Leistungshalbleiterbauteil, welches als Teil einer Inverterschaltung beschrieben ist, zu einem Kühlkörper, wobei zwischen dem Bauteil und dem Kühlkörper eine Leiterplatte angeordnet ist, welche auf beiden Seiten eine Metallschicht aufweist. Zur Verbesserung der Wärmeabfuhr und gleichzeitiger Insolation gegenüber dem Kühlkörper ist ein Metallkörper vorgesehen, welcher in der Leiterplatte angeordnet, und gegenüber dem Kühlkörper isoliert ist.

Die JP 2013 123014 A beschreibt ein flüssigkeitskühlbares Halbleitermodul.

Die US 4 853 828 A beschreibt eine Anordnung aus TO-220 Gehäusen, welche mit einem Kühlkörper verbunden sind. Dabei sind die Gehäuse elektrisch isoliert mit einem Aluminiumblock verbunden bzw. an einem solchen angeschraubt, welcher wiederum mit einem Kühlkörper verbunden ist.

Die EP2515331 A1 beschreibt ein Steuergerät zur Verbesserung der Genauigkeit des Messens der Temperatur eines Halbleiterelements.

Aufgabe der Erfindung ist es daher eine elektrische Bauteilanordnung der eingangs genannten Art anzugeben, mit welcher die genannten Nachteile vermieden werden können, mit welcher ein elektrischer Aufbau im Bereich der Leistungselektronik unter Verwendung diskreter Halbleiterbauelemente geschaffen werden kann, welcher eine hohe Betriebssicherheit bzw. Lebensdauer aufweist.

### [weiter auf Seite 2 der ursprünglichen Beschreibung]

Erfindungsgemäß wird dies durch die Merkmale des Patentanspruches 1 erreicht.

Dadurch kann ein elektrischer Aufbau bzw. eine Bauteilanordnung im Bereich der Leistungselektronik unter Verwendung diskreter Halbleiterbauelemente geschaffen werden, bei vergleichbaren Verlustleitungen wie bei Verwendung spezieller Leistungs-Halbleitermodule. Dadurch kann die Temperatur im Bereich der Halbleiterbauelemente auf ein vorgebbares Niveau gesenkt werden, welches eine hohe Betriebssicherheit bzw. Lebensdauer des Aufbaus ermöglicht. Dadurch ist es einfach möglich, insbesondere durch die jeweilige Dimensionierung der elektrisch leitenden Platte, die Temperatur in der Umgebung der Halbleiterbauelemente vorzugeben bzw. einzustellen. Dadurch kann erreicht werden, dass die Temperatur niedrig genug ist, um eine hohe Lebensdauer der Halbleiterbauelemente zu erzielen, jedoch hoch genug um nicht zur Kondenswasserbildung in einem Gerät zu führen, in dem die betreffende Bauteilanordnung angeordnet ist. Dadurch ist ein flexibler Einsatz in unterschiedlichen Vorrichtung gegeben. Dadurch können auch in Kleinserie elektrische bzw. elektronische Leistungsschaltungen hergestellt werden, welche eine hohe Leistungsdichte aufweisen.

Es hat sich dabei gezeigt, dass mit der gegenständlichen elektrischen Bauteilanordnung in der Praxis ein geringerer Wärmeübergangswiderstand erzielbar ist, als dieser bei, leistungsmäßig vergleichbaren, Halbleitermodulen angegeben wird. Dadurch ist mittels der gegenständlichen elektrischen Bauteilanordnung ein flexibler Aufbau möglich, welcher auch hinsichtlich der abführbaren Verlustleistung einem Aufbau in Form eines Halbleitermoduls nicht nachsteht, und dieser Form des Aufbaus sogar überlegen sein kann.

Die Unteransprüche betreffen weitere vorteilhafte Ausgestaltungen der Erfindung.

Ausdrücklich wird hiermit auf den Wortlaut der Patentansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 eine erste Ausführungsform einer gegenständlichen Bauteilanordnung in axonometrischer Darstellung;
Fig. 2 die Komponenten der Bauteilanordnung gemäß Fig. 1 in axonometrischer Explosionsdarstellung;
Fig. 3 eine zweite Ausführungsform einer gegenständlichen Bauteilanordnung in axonometrischer Darstellung;
Fig. 4 die Komponenten der Bauteilanordnung gemäß Fig. 3 in axonometrischer Explosionsdarstellung;
Fig. 5 die Bauteilanordnung gemäß Fig. 3 mit elektrischer kontaktierter leitender Platte in einer ersten axonometrischen Ansicht;
Fig. 6 die Bauteilanordnung gemäß Fig. 5 in einer zweiten axonometrischen Ansicht;
Fig. 7 die Komponenten der Bauteilanordnung gemäß Fig. 5 in axonometrischer Explosionsdarstellung; und
Fig. 8 ein Blockschaltbild einer gegenständlichen elektrischen Vorrichtung.

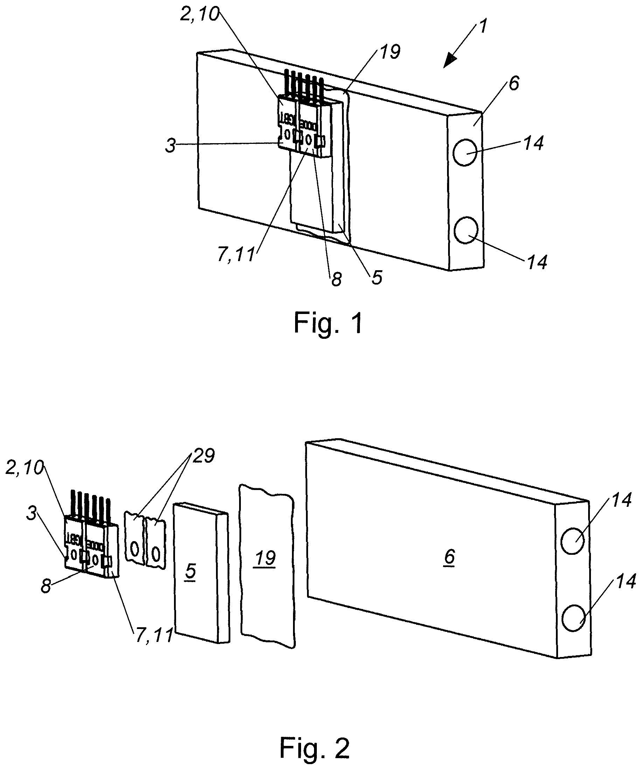

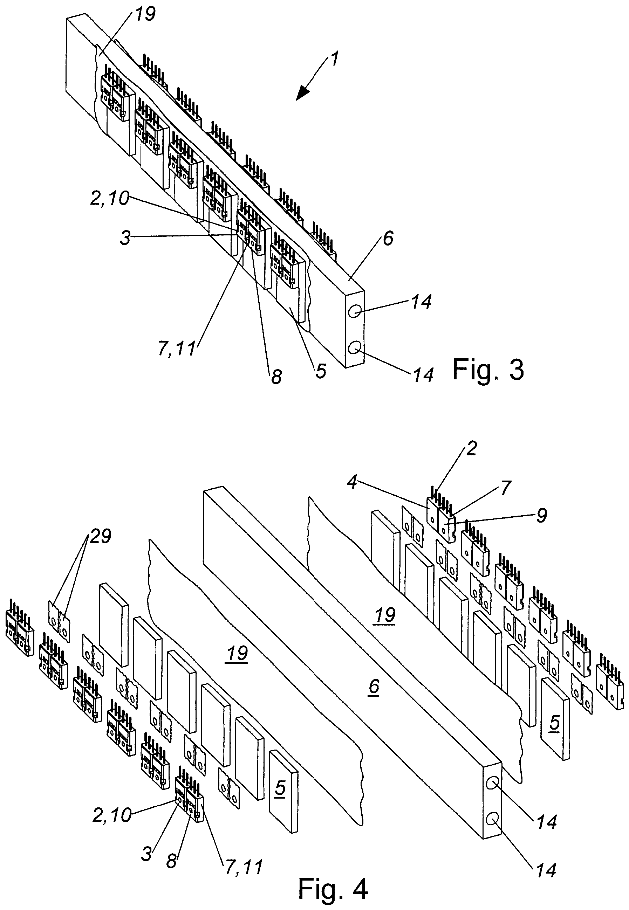

Die Fig. 1 bis 7 zeigen elektrische Bauteilanordnungen 1 bzw. die Komponenten entsprechender elektrischer Bauteilanordnungen 1, wobei die elektrische Bauteilanordnung 1 wenigstens ein erstes diskretes Halbleiterbauelement 2 aufweist, welches erste diskrete Halbleiterbauelement 2 ein erstes Gehäuse 3 mit einer ersten Gehäuseaußenfläche 4 aufweist, wobei die erste Gehäuseaußenfläche 4 als elektrischer Kontakt des ersten Halbleiterbauelements 2 ausgebildet ist, wobei die erste Gehäuseaußenfläche 4 elektrisch leitend mit einer elektrisch leitenden Platte 5 der elektrischen Bauteilanordnung 1 verbunden ist, wobei die elektrisch leitende Platte 5 elektrisch isoliert mit einem Kühlkörper 6 der elektrischen Bauteilanordnung 1 verbunden ist.

Dadurch kann ein elektrischer Aufbau bzw. eine Bauteilanordnung 1 im Bereich der Leistungselektronik unter Verwendung diskreter Halbleiterbauelemente 2, 7 geschaffen werden, bei vergleichbaren Verlustleitungen wie bei Verwendung spezieller Leistungs-Halbleitermodule. Dadurch kann die Temperatur im Bereich der Halbleiterbauelemente 2, 7 auf ein vorgebbares Niveau gesenkt werden, welches eine hohe Betriebssicherheit bzw. Lebensdauer des Aufbaus ermöglicht. Dadurch ist es einfach möglich, insbesondere durch die jeweilige Dimensionierung der elektrisch leitenden Platte 5, die Temperatur in der Umgebung der Halbleiterbauelemente 2, 7 vorzugeben bzw. einzustellen. Dadurch kann erreicht werden, dass die Temperatur niedrig genug ist, um eine hohe Lebensdauer der Halbleiterbauelemente 2, 7 zu erzielen, jedoch hoch genug um nicht zur Kondenswasserbildung in einem Gerät zu führen, in dem die betreffende Bauteilanordnung 1 angeordnet ist. Dadurch ist ein flexibler Einsatz in unterschiedlichen Vorrichtungen 15 gegeben. Dadurch können auch in Kleinserie elektrische bzw. elektronische Leistungsschaltungen hergestellt werden, welche eine hohe Leistungsdichte aufweisen. Es hat sich dabei gezeigt, dass mit der gegenständlichen elektrischen Bauteilanordnung 1 in der Praxis ein geringerer Wärmeübergangswiderstand erzielbar ist, als dieser bei, leistungsmäßig vergleichbaren, Halbleitermodulen angegeben wird. So konnte beispielsweise an einem, als IGBT 10 ausgebildeten, ersten Halbleiterbauelement 2 gemäß der gegenständlichen Bauteilanordnung 1 ein Wärmeübergangswiderstand mit einem Wert von 0,52 K/W erreicht werden. Bei einem leistungsmäßig vergleichbaren Aufbau eines namhaften Herstellers entsprechender Halbleitermodule beträgt der Wärmeübergangswiderstand in diesem Bereich immerhin ein K/W. Dadurch ist mittels der gegenständlichen elektrischen Bauteilanordnung ein flexibler Aufbau möglich, welcher auch hinsichtlich der abführbaren Verlustleistung einem Aufbau in Form eines Halbleitermoduls nicht nachsteht, und dieser Form des Aufbaus sogar überlegen sein kann.

Die Begriffe "und" sowie "oder" sind soweit nicht dezitiert angeführt jeweils im Sinne boolescher Operatoren zu verstehen.

Ein diskretes Halbleiterbauelement 2, 7 ist ein einzelnes, in einem eigenen Gehäuse 3, 8 angeordnetes elektrisches bzw. elektronisches Bauelement bzw. Schaltungselement, welches eigene äußere Anschlüsse aufweist. Im Gegensatz zu integrierten Schaltkreisen, welche mehrere elektrische Bauelemente in einem Gehäuse vereinigen. Der Einfachheit wegen kann die zusätzliche Angabe "diskret" teilweise nicht angeführt sein, wobei es sich trotzdem um diskrete Halbleiterbauelemente 2, 7 handelt.

Die gegenständliche Erfindung wird anhand der bevorzugten Ausführungsformen beschrieben, welche zumindest ein erstes und ein zweites diskretes Halbleiterbauelement 2, 7 aufweisen. Die Beschreibung soll dabei auch Ausführungsformen mit lediglich einem einzigen diskreten Halbleiterbauelement 2 sowie mit einer vorgebbaren Mehrzahl solcher diskreter Halbleiterbauelemente 2, 7 mit umfassen.

Das erste diskrete Halbleiterbauelement 2 ist bevorzugt als Halbleiterschaltelement, insbesondere als IGBT 10, ausgebildet. Es kann auch die Ausbildung des ersten Halbleiterbauelement 2 als anderes Leistungsschaltelement etwa als MosFet vorgesehen sein. Das zweite diskrete Halbleiterbauelement 7 ist bevorzugt als Diode 11 ausgebildet. In den Fig. 1 bis 7 sind an den jeweiligen Halbleiterbauelementen 2, 7 die Bezeichnungen IGBT bzw. Diode angeführt. Vorzugsweise ist in diesem Zusammenhang vorgesehen, dass das erste diskrete Halbleiterbauelement 2 und das zweite diskrete Halbleiterbauelement 7 in einer elektrischen Schaltung 16 ein funktional miteinander verschaltetes Halbleiterbauteilpaar 2, 7 bilden.

Die elektrische Bauteilanordnung 1 bezeichnet einen mechanischen Aufbau bzw. Zusammenbau elektrischer bzw. elektronischer Komponenten. Dabei beschreibt die gegenständliche elektrische Bauteilanordnung 1 die Anbindung eines diskreten Halbleiterbauelements 2 an einen Kühlkörper 6. Der Begriff "elektrische Bauteilanordnung 1" beschreibt dabei insbesondere keine Art der elektrischen Verschaltung bzw. funktionalen Kontaktierung des wenigstens einen diskreten Halbleiterbauelements 2, 7 im Rahmen einer elektrischen Schaltung 17, sondern lediglich den mechanischen Aufbau bzw. die mechanische Anordnung des betreffenden wenigstens einen diskreten Halbleiterbauelements 2, 7.

Das erste diskrete Halbleiterbauelement 2 weist zumindest zwei elektrische Anschlüsse auf. Dabei weist das erste diskrete Halbleiterbauelement 2 ein erstes Gehäuse 3 auf, welches erste Gehäuse 3 eine erste Gehäuseaußenfläche 4 aufweist, welche als elektrischer Kontakt des ersten Halbleiterbauelements 2 ausgebildet ist. Die betreffende erste Gehäuseaußenfläche 4 ist daher elektrisch leitend ausgebildet und innerhalb des ersten Gehäuses 3 mit einem Halbleitersubstrat des betreffenden ersten diskreten Halbleiterbauelements 2 verbunden.

Das zweite diskrete Halbleiterbauelement 7 weist ebenfalls zumindest zwei elektrische Anschlüsse auf. Dabei weist das zweite diskrete Halbleiterbauelement 7 ein zweites Gehäuse 8 auf, welches zweite Gehäuse 8 eine zweite Gehäuseaußenfläche 9 aufweist, welche als elektrischer Kontakt des zweiten Halbleiterbauelements 7 ausgebildet ist. Die betreffende zweite Gehäuseaußenfläche 9 ist daher elektrisch leitend ausgebildet und innerhalb des zweiten Gehäuses 8 mit einem Halbleitersubstrat des betreffenden zweiten diskreten Halbleiterbauelements 7 verbunden.

Bevorzugt ist vorgesehen, dass das erste Gehäuse 3 und/oder das zweite Gehäuse 8 als Standardhalbleitergehäuse, insbesondere als TO-220 oder TO-247, ausgebildet ist. Derartige Gehäuse 3, 8 weisen bereits entsprechend ausgebildete kontaktierte Gehäuseaußenflächen 4, 9 auf.

Die elektrische Bauteilanordnung 1 weist weiters einen Kühlkörper 6 auf, sowie eine elektrisch leitende Platte 5. Es ist vorgesehen, dass die erste Gehäuseaußenfläche 4 elektrisch leitend mit der elektrisch leitenden Platte 5 verbunden ist. Die elektrisch leitende Platte 5 ist weiters elektrisch isoliert mit dem Kühlkörper 6 verbunden.

Gemäß den bevorzugten Ausführungsformen ist vorgesehen, dass die zweite Gehäuseaußenfläche 9 neben der ersten Gehäuseaußenfläche 4 auf derselben elektrisch leitenden Platte 5 elektrisch leitend angeordnet ist. Daher sind bevorzugt zwei diskrete Halbleiterbauelemente 2, 7 auf derselben elektrisch leitenden Platte 5 angeordnet bzw. befestigt. Fig. 1 zeigt einen entsprechenden Aufbau. Fig. 2 zeigt die Komponenten des betreffenden Aufbaus in Explosionsdarstellung.

Die elektrisch leitende Platte 5 ist insbesondere umfassend Kupfer und/oder Aluminium und/oder Silber ausgebildet. Die elektrisch leitende Platte 5 ist daher als guter elektrischer Leiter ausgebildet um keine übermäßige zusätzliche Erwärmung an dieser Stelle zu verursachen. Dabei ist vorzugsweise vorgesehen, dass die elektrisch leitende Platte 5 eine Fläche aufweist, welche größer ist als die der Platte 5 zugewandten ersten bzw. zweiten Gehäuseaußenflächen 4, 9. Über die jeweilige Vorgabe der Größe bzw. der Fläche und Dicke der elektrisch leitenden Platte 5 kann der Wärmeübergangswiderstand erheblich beeinflusst werden. Durch entsprechend geeignete Wahl der betreffenden Parameter, sowie des Werkstoffes, kann einfach eine Zieltemperatur an den diskreten Halbleiterbauelementen 2, 7 erreicht werden.

In diesem Zusammenhang ist bevorzugt vorgesehen, dass die elektrisch leitende Platte 5 eine Fläche aufweist, welche 3 bis 7 mal, insbesondere 5 mal, so groß ist, wie die auf der Platte 5 angeordnete erste Gehäuseaußenfläche 4 und/oder zweite Gehäuseaußenfläche 9. Sofern lediglich ein erstes diskretes Halbleiterbauelement 2 auf der Platte 5 angeordnet ist, bezieht sich die Angabe zur Größe auf lediglich dieses erste diskretes Halbleiterbauelement 2. Sofern weiters ein zweites diskretes Halbleiterbauelement 7 auf der Platte 5 angeordnet ist, bezieht sich die Angabe zur Größe auf beide Halbleiterbauelemente 2, 7. Entsprechend ist bei weiteren Halbleiterbauelementen auf der Platte 5 zu verfahren. Vorzugsweise ist vorgesehen, dass für die gegenständliche Ermittlung der Fläche der Platte 5 lediglich die Fläche des elektrischen Kontakts auf der ersten bzw. zweiten Gehäuseaußenfläche 4, 9 berücksichtigt wird. Es kann sein, dass die betreffenden ersten bzw. zweiten Gehäuseaußenflächen 4, 9 neben einem elektrisch leitenden Kontaktbereich weiters elektrisch isolierte Bereiche, etwa einen Randbereich, aufweisen.

Bevorzugt ist vorgesehene, dass die erste und die zweite Gehäuseaußenflächen 4, 9 jeweils mit der elektrisch leitenden Platte 5 verlötet sind. In den Fig. 2, 4 und 7 ist entsprechend schematisch ein flächenförmig dargestelltes Lötzinn 29 abgebildet.

Es kann auch vorgesehen sein, die betreffenden Halbleiterbauelemente 2, 7 mit deren erster und die zweiter Gehäuseaußenfläche 4, 9 mechanisch gegen die Platte 5 zu drücken. Durch den derart erzeugten Kontaktdruck kann der elektrische wie auch der thermische Übergangswiderstand in diesem Bereich gesenkt werden. Dadurch kann in einer nicht dargestellten Ausführungsform auch auf das Lötzinn 29 in diesem Bereich verzichtet werden, indem die betreffenden Halbleiterbauelemente 2, 7 lediglich derart mechanisch an der Platte 5 gehalten sind. Bevorzugt wird der betreffende Kontaktdruck mittels wenigstens einer Feder und/oder Klammer aufgebracht. Dabei kann vorgesehen sein, dass eine Klammer die Kühlschiene bzw. den Kühlkörper 6 umgreift und die Halbleiterbauelemente 2, 7, welche gemäß den bevorzugten Ausführungsformen beidseitig der Kühlschiene angeordnet sind, jeweils gegen die ihnen zugeordnete Platte 5 drückt.

Es kann weiters vorgesehen sein, zwischen der Platte 5 und der ersten und zweiten Gehäuseaußenfläche 4, 9 ein elektrisch leitendes Öl oder eine entsprechende Paste oder einen Kleber vorzusehen.

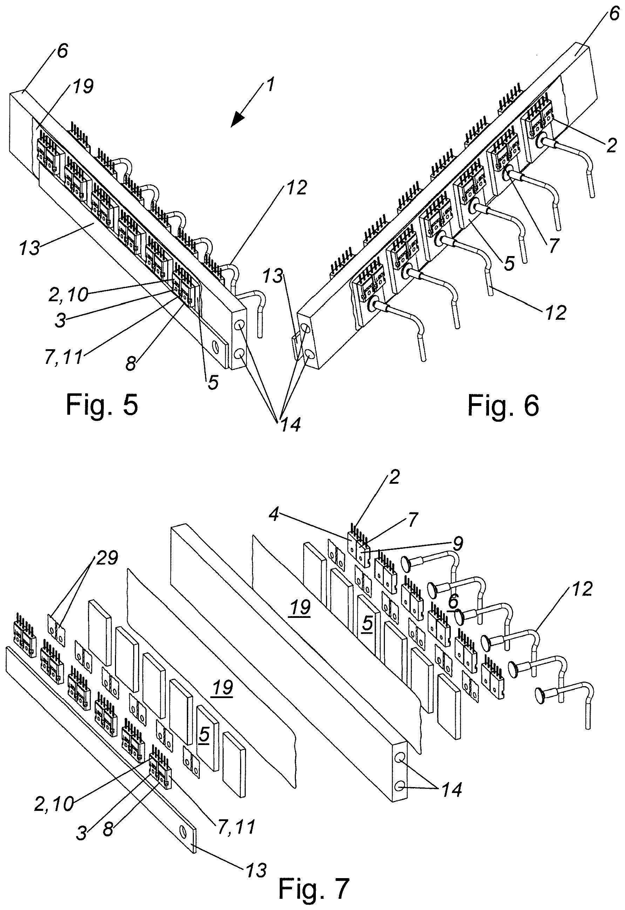

Die elektrisch leitende Platte 5 ist weiters bevorzugt mit einer elektrischen Versorgungsleitung 12, insbesondere einer Stromschiene 13, elektrisch leitend verbunden. Dadurch kann ein niederohmiger Anschluss der betreffenden Halbleiterbauelemente 2, 7 erzielt werden. In den Fig. 5, 7 und 7 sind jeweils eine Stromschiene 13, sowie drahtförmig ausgebildete Versorgungsleitungen 12 dargestellt, welche jeweils die Platte 5 kontaktieren.

Der Kühlkörper 6 ist bevorzugt als fluidgekühlter, insbesondere als flüssigkeitsgekühlter, Kühlkörper 6 umfassend Fluiddurchtrittskanäle 14 ausgebildet, insbesondere als Kühlschiene, wie in den Fig. 1 bis 7 dargestellt. Dabei kann auch vorgesehen sein, den Kühlkörper 6 als passiven Kühlkörper auszubilden, etwa umfassend Kühlrippen.

Die elektrisch leitende Platte 5 ist elektrisch isoliert mit dem Kühlkörper 6 verbunden. Dabei ist bevorzugt vorgesehen, dass zwischen der Platte 5 und dem Kühlkörper 6 eine elektrische Isolierschicht 19 bzw. Isolierfolie, mit vorzugsweise geringem Wärmeübergangswiderstand bei guter elektrischer Isolierfähigkeit, angeordnet. Eine derartige Isolierschicht 19 ist in den Fig. 1 bis 7 eingezeichnet.

Gemäß einer besonders bevorzugten Ausführungsform ist vorgesehen, dass der Kühlkörper 6 als Keramikkühlkörper, vorzugsweise umfassend bzw. bestehend aus Aluminiumnitrid, ausgebildet ist. Aluminiumnitrid weist eine hohe thermische Leitfähigkeit bei gleichzeitig hohem elektrischen Widerstand auf. Dadurch kann auf die Isolierschicht 19 verzichtet werden.

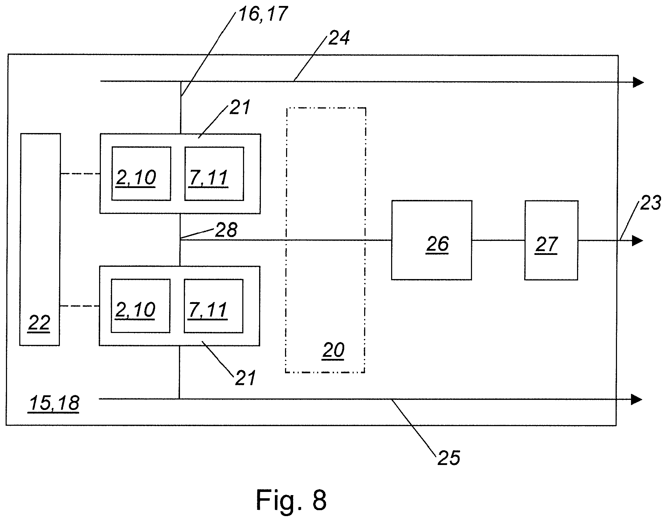

Fig. 8 zeigt ein schematisches Blockschaltbild einer besonders bevorzugten elektrischen Vorrichtung mit einer gegenständlichen elektrischen Bauteilanordnung 1. Die betreffende elektrische Vorrichtung 15 ist dabei als Wechselrichter 18 ausgebildet. Es kann dabei vorgesehen sein, die elektrische Vorrichtung 15 als andere elektrische Vorrichtung 15 auszubilden. Die elektrische Vorrichtung 15 gemäß Fig. 8 weist wenigstens eine elektrische Schaltung 16 auf, welche elektrische Schaltung 16 das erste diskrete Halbleiterbauelement 2 und das zweite diskrete Halbleiterbauelement 7 umfasst, wobei selbstverständlich auch eine größere Anzahl an Halbleiterbauelementen 2, 7 vorgesehen sein kann.

Gemäß der in Fig. 8 dargestellten bevorzugten Ausführungsform, weist die als Wechselrichter 18 ausgebildete elektrische Vorrichtung 15 wenigstens eine elektrische Halbbrücke 17 auf, wobei in Fig. 8 lediglich eine derartige Halbbrücke 17 eingezeichnet ist, und weitere Halbbrücken 17 durch das strich-punktiert umrandete Feld 20 symbolisiert sind.

Die wenigstens eine elektrische Halbbrücke 17 weist zwei variable Widerstände 21 auf, welche gemäß der bevorzugten Ausführungsform jeweils durch eine Paarung bzw. Verschaltung des, als IGBT 10 ausgebildeten, ersten diskreten Halbleiterbauelements 2 sowie des, als Diode 11 bzw. Freilaufdiode ausgebildeten, zweiten diskreten Halbleiterbauelements 7 gebildet sind. Die Diode 11 ist dabei in an sich bekannter und nicht dargestellter Weise parallel zu dem Schaltelement bzw. dem IGBT 10 geschaltet.

Die Halbbrücke 17 weist einen Ausgang 28 zwischen den beiden variablen Widerständen 21 auf, welcher mit einer Spulenanordnung 26 verbunden ist, welche weiters mit einem Tiefpassfilter 27 verbunden ist, dessen Ausgang einen Wechselstromanschluss 23 der Vorrichtung 15 bildet. Weiters weist die elektrische Vorrichtung 15 gemäß Fig. 8 zwei Gleichstromanschlussleitungen 24, 25 auf, sowie eine Ansteuereinheit 22, welche die variablen Widerstände 21 vorgebbar ansteuert.

## Patentansprüche

1. Elektrische Vorrichtung (15) mit einer elektrischen Bauteilanordnung (1) mit wenigstens einem ersten diskreten Halbleiterbauelement (2), welches erste diskrete Halbleiterbauelement (2) ein erstes Gehäuse (3) mit einer ersten Gehäuseaußenfläche (4) aufweist, wobei die erste Gehäuseaußenfläche (4) als elektrischer Kontakt des ersten Halbleiterbauelements (2) ausgebildet ist, wobei die erste Gehäuseaußenfläche (4) elektrisch leitend mit einer elektrisch leitenden Platte (5) der elektrischen Bauteilanordnung (1) verbunden ist, und wobei die elektrisch leitende Platte (5) elektrisch isoliert mit einem Kühlkörper (6) der elektrischen Bauteilanordnung (1) verbunden ist, wobei die elektrische Bauteilanordnung (1) weiters ein zweites diskretes Halbleiterbauelement (7) umfasst, welches zweite diskrete Halbleiterbauelement (7) ein zweites Gehäuse (8) mit einer zweiten, als elektrischer Kontakt des zweiten Halbleiterbauelements (7) ausgebildeten, Gehäuseaußenfläche (9) aufweist, wobei die zweite Gehäuseaußenfläche (9) neben der ersten Gehäuseaußenfläche (4) auf derselben elektrisch leitenden Platte (5) elektrisch leitend angeordnet ist, wobei das erste Gehäuse (3) und das zweite Gehäuse (8) als Standardhalbleitergehäuse ausgebildet ist, wobei die elektrische Vorrichtung (15) wenigstens eine elektrische Schaltung (16) aufweist, wobei die elektrische Schaltung (16) das erste diskrete Halbleiterbauelement (2) und das zweite diskrete Halbleiterbauelement (7) umfasst, **dadurch gekennzeichnet, dass** zwischen der Platte (5) und dem Kühlkörper (6) eine elektrische Isolierschicht (19) bzw. Isolierfolie, mit geringem Wärmeübertragungswiderstand bei guter elektrischer Isolierfähigkeit, angeordnet ist.

2. Elektrische Vorrichtung (15) nach Anspruch 1, **dadurch gekennzeichnet, dass** das erste diskrete Halbleiterbauelement (2) als Halbleiterschaltelement, insbesondere als IGBT (10), ausgebildet ist, dass das zweite diskrete Halbleiterbauelement (7) als Diode (11) ausgebildet ist.

3. Elektrische Vorrichtung (15) nach Anspruch 1 oder 2, **dadurch gekennzeichnet, dass** die elektrisch leitende Platte (5) umfassend Kupfer und/oder Aluminium und/oder Silber ausgebildet ist.

4. Elektrische Vorrichtung (15) nach Anspruch 3, **dadurch gekennzeichnet, dass** die elektrisch leitende Platte (5) eine Fläche aufweist, welche 3 bis 7 mal, insbesondere 5 mal, so groß ist, wie die auf der Platte (5) angeordnete erste Gehäuseaußenfläche (4) und/oder zweite Gehäuseaußenfläche (9).

5. Elektrische Vorrichtung (15) nach einem der Ansprüche 1 bis 4, **dadurch gekennzeichnet, dass** die elektrisch leitende Platte (5) mit einer elektrischen Versorgungsleitung (12), insbesondere einer Stromschiene (13), elektrisch leitend verbunden ist.

6. Elektrische Vorrichtung (15) nach einem der Ansprüche 1 bis 5, **dadurch gekennzeichnet, dass** der Kühlkörper (6) als fluidgekühlter Kühlkörper (6) umfassend Fluiddurchtrittskanäle (14), insbesondere als Kühlschiene, ausgebildet ist.

7. Elektrische Vorrichtung (15) nach einem der Ansprüche 1 bis 6, **dadurch gekennzeichnet, dass** der Kühlkörper (6) als Keramikkühlkörper, vorzugsweise umfassend Aluminiumnitrid, ausgebildet ist.

8. Elektrische Vorrichtung (15) nach einem der Ansprüche 2 bis 7, **dadurch gekennzeichnet, dass** das zweite diskrete Halbleiterbauelement (7) als Freilaufdiode parallel zu dem ersten diskreten Halbleiterbauelement (2) in der elektrischen Schaltung (16) geschaltet ist.

9. Elektrische Vorrichtung (15) nach einem der Ansprüche 1 bis 8, **dadurch gekennzeichnet, dass** die elektrische Vorrichtung (15) als Wechselrichter (18) ausgebildet ist, umfassend wenigstens eine elektrische Halbbrücke (17), und dass das erste diskrete Halbleiterbauelement (2) und das zweite diskrete Halbleiterbauelement (7) gemeinsam einen variablen Widerstand der elektrischen Halbbrücke (17) bilden.

## Claims

1. Electrical device (15) comprising an electrical component assembly (1) having at least one first discrete semiconductor component (2), which first discrete semiconductor component (2) has a first housing (3) with a first housing outer surface (4), wherein the first housing outer surface (4) is designed as an electrical contact of the first semiconductor component (2), wherein the first housing outer surface (4) is electrically conductively connected to an electrically conductive plate (5) of the electrical component assembly (1), and wherein the electrically conductive plate (5) is connected in an electrically insulating manner to a heat sink (6) of the electrical component assembly (1), wherein the electrical component assembly (1) further comprises a second discrete semiconductor component (7), which second discrete semiconductor component (7) has a second housing (8) with a second housing outer surface (9) formed as an electrical contact of the second semiconductor component (7), wherein the second housing outer surface (9) is arranged in an electrically conductive manner adjacent to the first housing outer surface (4) on the same electrically conductive plate (5), wherein the first housing (3) and the second housing (8) are formed as a standard semiconductor housing, wherein the electrical device (15) comprises at least one electrical circuit (16), wherein the electrical circuit (16) comprises the first discrete semiconductor component (2) and the second discrete semiconductor component (7), **characterized in that** an electrically insulating layer (19) or insulating film, having low heat transfer resistance with good electrical insulating ability, is arranged between the plate (5) and the heat sink (6).

2. Electrical device (15) according to claim 1, **characterized in that** the first discrete semiconductor component (2) is designed as a semiconductor switching element, in particular as an IGBT (10), **in that** the second discrete semiconductor component (7) is designed as a diode (11).

3. Electrical device (15) according to claim 1 or 2, **characterized in that** the electrically conductive plate (5) is formed comprising copper and/or aluminum and/or silver.

4. Electrical device (15) according to claim 3, **characterized in that** the electrically conductive plate (5) has an area which is 3 to 7 times, in particular 5 times, as large as the first housing outer surface (4) and/or second housing outer surface (9) arranged on the plate (5).

5. Electrical device (15) according to one of claims 1 to 4, **characterized in that** the electrically conductive plate (5) is electrically conductively connected to an electrical supply line (12), in particular a busbar (13).

6. Electrical device (15) according to one of claims 1 to 5, **characterized in that** the heat sink (6) is designed as a fluid-cooled heat sink (6) comprising fluid passage channels (14), in particular as a cooling rail.

7. Electrical device (15) according to one of claims 1 to 6, **characterized in that** the heat sink (6) is designed as a ceramic heat sink, preferably comprising aluminum nitride.

8. Electrical device (15) according to one of claims 2 to 7, **characterized in that** the second discrete semiconductor component (7) is connected as a freewheeling diode in parallel with the first discrete semiconductor component (2) in the electrical circuit (16).

9. Electrical device (15) according to one of claims 1 to 8, **characterized in that** the electrical device (15) is formed as an inverter (18) comprising at least one electrical half-bridge (17), and **in that** the first discrete semiconductor device (2) and the second discrete semiconductor device (7) together form a variable resistance of the electrical half-bridge (17).

## Revendications

1. Dispositif électrique (15) avec une disposition de composants électriques (1) comprenant au moins un premier élément semiconducteur discret (2), lequel premier élément semiconducteur discret (2) comporte un premier boîtier (3) avec une première surface extérieure de boîtier (4), la première surface extérieure de boîtier (4) étant conformée comme un contact électrique du premier élément semiconducteur (2), la première surface extérieure de boîtier (4) étant reliée de façon conductrice électrique à une plaque conductrice électrique (5) de la disposition de composants électriques (1) et la plaque conductrice électrique (5) étant reliée de façon isolée électriquement à un radiateur (6) de la disposition de composants électriques (1), dans lequel la disposition de composants électriques (1) comprend en outre un deuxième élément semiconducteur discret (7), lequel élément semiconducteur discret (7) comporte un deuxième boîtier (8) avec une deuxième surface extérieure de boîtier (9) conformée comme un contact électrique du deuxième élément semiconducteur (7), la deuxième surface extérieure de boîtier (9) étant disposée de façon électriquement conductrice à côté de la première surface extérieure de boîtier (4) sur la même plaque conductrice électrique (5), dans lequel le premier boîtier (3) et le deuxième boîtier (8) sont conformés comme des boîtiers de semiconducteurs standard, le dispositif électrique (15) comportant au moins un circuit électrique (16), lequel circuit électrique (16) comprend le premier élément semiconducteur discret (2) et le deuxième élément semiconducteur discret (7), **caractérisé en ce qu'**une couche isolante électrique (19) ou un film isolant, ayant une faible conductibilité thermique pour un bon pouvoir isolant électrique, est disposée entre la plaque (5) et le radiateur (6).

2. Dispositif électrique (15) selon la revendication 1, **caractérisé en ce que** le premier élément semiconducteur discret (2) est conformé comme un élément semiconducteur, en particulier comme un IGBT (10), et **en ce que** le deuxième élément semiconducteur discret (7) est conformé comme une diode (11).

3. Dispositif électrique (15) selon la revendication 1 ou 2, **caractérisé en ce que** la plaque conductrice électrique (5) contient du cuivre et/ou de l'aluminium et/ou de l'argent.

4. Dispositif électrique (15) selon la revendication 3, **caractérisé en ce que** la plaque conductrice électrique (5) a une aire qui est 3 à 7 fois, en particulier 5 fois plus grande que la première surface extérieure de boîtier (4) disposée sur la plaque (5) et/ou la deuxième surface extérieure de boîtier (9).

5. Dispositif électrique (15) selon l'une des revendications 1 à 4, **caractérisé en ce que** la plaque conductrice électrique (5) est reliée de façon conductrice électrique à une ligne d'alimentation électrique (12), en particulier une barre collectrice (13).

6. Dispositif électrique (15) selon l'une des revendications 1 à 5, **caractérisé en ce que** le radiateur (6) est conçu comme un radiateur (6) refroidi par fluide comprenant des canaux de passage de fluide (14), formant en particulier un rail de refroidissement.

7. Dispositif électrique (15) selon l'une des revendications 1 à 6, **caractérisé en ce que** le radiateur (6) est conformé comme un radiateur en céramique, contenant de préférence du nitrure d'aluminium.

8. Dispositif électrique (15) selon l'une des revendications 2 à 7, **caractérisé en ce que** le deuxième élément semiconducteur discret (7) est monté sous la forme d'une diode de roue libre en parallèle avec le premier élément semiconducteur discret (2) dans le circuit électrique (16).

9. Dispositif électrique (15) selon l'une des revendications 1 à 8, **caractérisé en ce que** le dispositif électrique (15) est conformé comme un onduleur (18) comprenant au moins un demi-pont électrique (17) et **en ce que** le premier élément semiconducteur discret (2) et le deuxième élément semiconducteur discret (7) forment ensemble une résistance variable du demi-pont électrique (17).
